# EUROPÄISCHE PATENTSCHRIFT

(11) **EP 4 063 890 B1**
(45) Veröffentlichungstag und Bekanntmachung des Hinweises auf die Patenterteilung: **03.07.2024**
(21) Anmeldenummer: 21164156.8
(22) Anmeldetag: 23.03.2021
(51) Int. Cl.: G01R 33/565

(54) **ERKENNEN EINER HF-STÖRUNG BEI EINEM MAGNETRESONANZTOMOGRAPHIESYSTEM**
DETECTION OF HF INTERFERENCE IN A MAGNETIC RESONANCE IMAGING SYSTEM
DÉTECTION D'INTERFÉRENCES RF DANS UN SYSTÈME DE TOMOGRAPHIE PAR RÉSONANCE MAGNÉTIQUE

(43) Veröffentlichungstag der Anmeldung: 28.09.2022
(73) Patentinhaber: Siemens Healthineers AG, 91301 Forchheim (DE)
(72) Erfinder: Grodzki, David, 91058 Erlangen (DE); Kannengießer, Stephan, 42113 Wuppertal (DE)
(74) Vertreter: Siemens Healthineers Patent Attorneys

(56) Entgegenhaltungen:
- WO-A2-2019/068687
- US-A1- 2021 025 954

## Beschreibung

Die vorliegende Erfindung betrifft ein Verfahren zum Erkennen einer HF-Störung (Hochfrequenz; englisch: RF, radio frequency) bei der Bildgebung eines Magnetresonanztomographiesystems durch Ausführen einer Akquisition, bei der eine Abtastung eines k-Raums entlang einer Trajektorie erfolgt, wobei ein Winkel α zwischen einer Abtaststartposition einer ersten Einzelakquisition und einer Abtaststartposition einer folgenden zweiten Einzelakquisition besteht, und Gewinnen eines ersten Bilds aus der ersten Einzelakquisition und eines zweiten Bilds aus der zweiten Einzelakquisition. Darüber hinaus betrifft die vorliegende Erfindung ein Computerprogrammprodukt. Des Weiteren betrifft die vorliegende Erfindung ein Magnetresonanztomographiesystem zum Erkennen einer HF-Störung bei der Bildgebung mit einer Tomographieeinrichtung und einer Bildverarbeitungseinrichtung zum Durchführen der Akquisitionen und Bildgewinnungen.

Systeme zur Magnetresonanztomographie, MRT, sind bildgebende Vorrichtungen, die zur Abbildung eines Untersuchungsobjekts Kernspins des Untersuchungsobjekts mit einem starken äußeren Magnetfeld ausrichten und durch ein magnetisches Wechselfeld zur Präzession um die entsprechende Ausrichtung anregen. Die Präzession beziehungsweise die Rückkehr der Spins aus diesem angeregten Zustand in einen Zustand mit geringerer Energie wiederum erzeugt als Antwort ein magnetisches Wechselfeld, das über Empfangsantennen detektiert werden kann.

Mithilfe von magnetischen Gradientenfeldern kann den Signalen eine Ortscodierung aufgeprägt werden, die nachfolgend eine Zuordnung von dem empfangenen Signal zu einem Volumenelement des Untersuchungsobjekts ermöglicht. Das empfangene Signal kann dann ausgewertet werden, beispielsweise um eine dreidimensionale bildgebende Darstellung des Untersuchungsobjekts bereitzustellen. Als Empfangsantennen können beispielsweise lokale Empfangsantennen, sogenannte Lokalspulen, verwendet werden, die zur Erzielung eines besseren Signal-Rausch-Verhältnisses, SNR, unmittelbar an dem Untersuchungsobjekt angeordnet werden können. Die Empfangsantennen können aber auch in der Umgebung des Untersuchungsobjekts angeordnet sein oder beispielsweise in einer Patientenliege verbaut sein.

Die für die Bildgebung zu empfangenden MRT-Signale sind extrem schwach, sodass bei bekannten MRT-Systemen eine Abschirmung externer Störsignale erforderlich ist, um ein ausreichendes SNR zu erreichen. Dazu werden insbesondere aufwendige Schirmkabinen installiert, um die störenden Immissionen zu reduzieren. Dies führt zu erheblichen Kosten und baulichen Einschränkungen aufgrund des entsprechenden Platzbedarfs.

Im Dokument WO 2019/068687 A2 werden ein Magnetresonanztomograph mit aktiver Störunterdrückung und ein entsprechendes Verfahren beschrieben. Dabei ist eine erste Empfangsantenne zum Empfang eines Magnetresonanzsignals aus einem Patienten vorgesehen und eine zweite Empfangsantenne zum Empfang eines Störsignals. Ein mit den Empfangsantennen verbundener Empfänger ist dazu ausgelegt, das mit der zweiten Empfangsantenne empfangene Störsignal in dem von der ersten Empfangsantenne empfangenen Magnetresonanzsignal zu unterdrücken. Dazu wird das Störsignal während der MRT-Sequenzen zur Signalakquisition bestimmt, wobei Zeitabschnitte genutzt werden können, in denen kein MRT-Signal zur Bildgebung erwartet wird. Eine Entstörsteuerung kann dann die Signale der ersten Empfangsspule und der zweiten Empfangsspule gewichtet kombinieren, um die Energie des Störsignals in dem kombinierten Signal zu minimieren.

Das Dokument US 2021/025954 A1 beschreibt ein Verfahren zur Unterdrückung eines Störsignals während einer Bilderfassung mit einem Magnetresonanztomographen, der eine Antenne und einen Störsignalsensor aufweist. Der Magnetresonanztomograph empfängt ein Referenz-Störsignal mit dem Störsignalsensor, ein Magnetresonanzsignal mit der Antenne und reduziert einen Anteil eines Störsignals in dem Magnetresonanzsignal in Abhängigkeit von dem Referenz-Störsignal. Beim Reduzieren berücksichtigt das Verfahren, dass das Referenz-Störsignals auch einen Anteil des Magnetresonanzsignals aufweist.

Da diese Abschnitte je nach verwendeter MRT-Sequenz unterschiedlich lang sind und zu unterschiedlichen Zeiten auftreten, muss das Vorgehen zur Entstörung individuell auf jede MRT-Sequenz angepasst werden, was zu einem erhöhten Aufwand führt. Zudem kann es je nach MRT-Sequenz möglich sein, dass die zur Verfügung stehenden Abschnitte zur Bestimmung des Störsignals nicht ausreichend lang sind, um eine zuverlässige Unterdrückung des Einflusses der Störung zu erreichen.

Heutige MRT-Systeme sind in der Regel von der oben genannten Schirmkabine beziehungsweise HF-Kabine umgeben. Diese ist zum einen dafür gedacht, von außen eindringende HF-Störer, die die MR-Messung behindern würden, auszuschließen und zum anderen, um zu verhindern, dass die vom MRT applizierte HF-Strahlung nach außen dringt und möglicherweise andere Geräte stört. Im vorliegenden Dokument wird jedoch speziell die Erkennung und Beseitigung von Störern betrachtet, die von außen auf die MR-Messung einwirken. Der Aufbau einer diesbezüglichen HF-Kabine kann sehr komplex sein und ist üblicherweise mit hohen Kosten verbunden.

Weiterhin gibt es Ansätze (nicht druckschriftlich belegbar), die sich mit der Frage beschäftigen, ob beziehungsweise wie ein MRT System ohne eine HF-Kabine betrieben werden kann. Die meisten diesbezüglichen Methoden stützen sich auf zusätzliche Antennen in der Nähe des MRT-Systems, sogenannte Pick-up-Antennen.

Die Aufgabe der vorliegenden Erfindung besteht darin, ein Verfahren zur Erkennung von HF-Störern bei Magnetresonanztomographiesystemen vorzuschlagen, wobei auf HF-Kabinen verzichtet und trotzdem eine verbesserte Störererkennung möglich ist.

Erfindungsgemäß wird diese Aufgabe gelöst durch die Gegenstände der unabhängigen Ansprüche. Vorteilhafte Weiterbildungen der Erfindung ergeben sich aus den Unteransprüchen.

Erfindungsgemäß wird demnach ein Verfahren zum Erkennen einer HF-Störung bei der Bildgebung eines Magnetresonanztomographiesystems bereitgestellt. Unter einer HF-Störung, also Hochfrequenzstörung, werden hier Störungen betrachtet, deren ursächliche Frequenzen höher als 1 kHz liegen und die sich bei der Bildgebung eines Magnetresonanztomographiesystems bemerkbar machen können. Insbesondere sind die derartigen HF-Störungen häufig für Artefakte auf den gewonnenen MRT-Bildern verantwortlich. Speziell können sich diese HF-Störungen als Punkte, Linien und dergleichen in den gewonnenen Bildern bemerkbar machen.

In einem ersten Schritt erfolgt das Ausführen einer Akquisition, bei der eine Abtastung eines k-Raums (Phasenkodierung über der Frequenzkodierung)entlang einer Trajektorie erfolgt, wobei ein Drehwinkel α zwischen einer Abtaststartposition einer ersten Einzelakquisition und einer Abtaststartposition einer folgenden zweiten Einzelakquisition besteht. Eine Akquisition besteht also in der Regel aus mehreren Einzelakquisitionen. Die genannte zweite Einzelakquisition kann unmittelbar der ersten Einzelakquisition folgen. Es können aber auch eine oder mehrere Einzelakquisitionen zwischen der ersten und der zweiten Einzelakquisition stattfinden.

Bei der Akquisition des Magnetresonanztomographiesystems erfolgt eine Abtastung des k-Raums. Die Akquisition umfasst mehrere Einzelakquisitionen, bei denen entlang einer jeweiligen Trajektorie abgetastet wird. Die Abtaststartpositionen der Trajektorien der Einzelakquisitionen sind zueinander um einen Drehwinkel α gedreht. Dies führt dazu, dass die bei den Einzelakquisitionen gewonnenen Bilder ebenfalls zueinander um den Drehwinkel α gedreht sind.

In einem weiteren Verfahrensschritt werden ein erstes Bild aus der ersten Einzelakquisition und ein zweites Bild aus der zweiten Einzelakquisition gewonnen. Bei jeder Einzelakquisition entstehen Datensätze, aus denen jeweilige Bilder zu gewinnen sind. Dieses Gewinnen jeweiliger Bilder kann mit bekannten Algorithmen der Bildverarbeitung für Magnetresonanztomographiesysteme erfolgen.

Nun findet ein Drehen eines der beiden Bilder gegenüber dem anderen Bild um den Drehwinkel α statt. Es wird also das erste Bild aus der ersten Einzelakquisition gegenüber dem zweiten Bild aus der zweiten Einzelakquisition beziehungsweise umgekehrt gedreht. Die Drehung erfolgt genau um den gleichen Drehwinkel α, aber in der Regel in umgekehrter Richtung. Dies bedeutet, dass die Drehung auf der Bildebene praktisch rückgängig gemacht wird, indem beispielsweise das zweite Bild "zurückgedreht" wird. Bei diesem Drehen beziehungsweise Zurückdrehen drehen sich auch die Positionen von Einzelkomponenten des Objekts um die gleiche Drehachse.

Anschließend erfolgt ein Ermitteln einer Korrelation zwischen dem einen gedrehten und dem anderen Bild. Unter Korrelation wird hier jegliche Beziehung zwischen den beiden Bildern verstanden. Eine solche Beziehung kann beispielsweise darin gesehen werden, dass gewisse Bildkomponenten der einzelnen Bilder beim Drehen aufeinander zu- und andere voneinander wegbewegt werden. Wird beispielsweise eine Objektkomponente in beiden Bildern dargestellt, so befindet sie sich wegen der Drehung der Abtaststartpositionen in beiden Bildern an unterschiedlichen Bildpositionen. Werden die Bilder daher so zueinander gedreht, dass ihre Ränder deckungsgleich sind, d.h. um den Drehwinkel α zueinander verdreht, wandern die korrespondierenden Bildpunkte der gleichen Objektkomponente auseinander. Anders verhält es sich bei Störungen. Diese treten in aller Regel an einer festen Bildposition auf. Dies bedeutet, dass beim Drehen der einzelnen Bilder zueinander, so dass die Bildränder deckungsgleich sind, die Störungen beziehungsweise Artefakte aufeinander zubewegt werden und letztlich aufeinanderliegen beziehungsweise die gleiche Bildposition besitzen. Dies bedeutet, dass ein Störpunkt aus der Korrelation, die sich aus den beiden Bildern ergibt, identifizieren lässt. Während also in den zueinander gedrehten Bildern die Bildkomponenten des abzubildenden Objekts nicht oder nur gering korreliert sind, sind Störungen beziehungsweise Störpunkte, die von der Drehung der Abtasttrajektorien unbeeinflusst sind, stark korreliert und damit entsprechend gut identifizierbar.

In einer weiter entwickelten Ausführungsform ist vorgesehen, dass bei dem Ausführen der Akquisition mindestens eine weitere Einzelakquisition erfolgt, bei der die Abtaststartposition wiederum um einen Drehwinkel α gegenüber der zweiten Einzelakquisition gedreht ist, und aus der mindestens einen weiteren Einzelakquisition mindestens ein weiteres Bild gewonnen wird, das entsprechend gedreht bei der Korrelation berücksichtigt wird. Dies bedeutet, dass nicht nur zwei Bilder miteinander korreliert werden, um eine HF-Störung zu detektieren, sondern mindestens drei, vier oder mehr Bilder. Auf diese Weise lässt sich noch sicherer feststellen, ob ein Bildpunkt das aufzunehmende Objekt wiedergibt oder eine Störung darstellt.

In einer Weiterbildung kann vorgesehen sein, dass das Identifizieren des Störpunkts durch einen Mustererkennungsalgorithmus erfolgt. Die Korrelation der Bilder kann beispielsweise zu gewissen Bildpunkten führen, die ein bekanntes beziehungsweise festgelegtes Muster bilden. Ein derartiges Muster kann als Störung bekannt sein. Der auf ein solches Muster ausgelegte Mustererkennungsalgorithmus kann daher eine diesbezügliche Störung identifizieren.

Weiterhin kann vorgesehen sein, dass das Identifizieren des Störpunkts einen Vergleich mit einem Schwellwert beinhaltet. Ist beispielsweise nach der Korrelation die Signalintensität an einer Störstelle höher als ein Schwellwert, weil die Bildpunkte in den jeweiligen Bildern entsprechend korreliert sind, so deutet dies auf einen Störpunkt beziehungsweise eine Störung oder einen HF-Störer hin. Weniger korrelierte Bildpunkte liegen dann beispielsweise unterhalb des Schwellwerts und werden nicht als Störpunkte registriert. Ein derartiger Schwellwertvergleich (Thresholding) führt deswegen oft zum Erfolg, da die Signalintensität der Störer meist höher als das umgebende MR-Signal ist.

In einem weiteren Ausführungsbeispiel kann die Korrelation durch eine Subtraktion betroffener Bilder ermittelt. So können im Rahmen der Korrelation beispielsweise die einzelnen Bilder nach dem Drehen voneinander subtrahiert werden. Eine derartige Subtraktion macht Strukturen sichtbar, die sich in beiden Bildern an den gleichen Positionen befinden. Andere Bildkomponenten, die beim Drehen zueinander verschoben sind, heben sich dagegen bei der Subtraktion nicht auf. Insofern kann durch eine einfache Subtraktion eine Korrelation der beiden Bilder realisiert werden.

Des Weiteren kann vorgesehen sein, dass das Identifizieren des Störpunkts auf einem maschinellen Lernalgorithmus, insbesondere einem Deep-Learning-Algorithmus, basiert. Bei dem maschinellen Lernen kann beispielsweise ein statisches Modell zugrunde gelegt werden, das mit Trainingsdaten angelernt wird. Bei dem Deep-Learning-Algorithmus kann ein künstliches neuronales Netz zum Einsatz kommen.

Gemäß einem weiteren Ausführungsbeispiel soll der Störpunkt in den Bildern markiert, gelöscht oder ersetzt werden. Der Störpunkt kann beispielsweise dazu markiert werden, damit der Betrachter sofort erkennt, dass er sich auf diesen Störpunkt nicht verlassen kann. Insbesondere soll der Wert dieses Störpunkts beispielsweise nicht für eine Diagnose herangezogen werden. Alternativ kann der identifizierte Störpunkt aber auch gelöscht werden. Beispielsweise erhält er hierbei den Wert null und fällt somit nicht durch hohe Signalintensität auf. Weiter alternativ kann vorgesehen sein, dass der Störpunkt ersetzt wird, d.h., der Bildpunkt an der jeweiligen Stelle erhält einen anderen Signalwert. So kann er beispielsweise den mittleren Signalwert derjenigen Bildpunkte erhalten, die den Störpunkt umgeben.

Das Abtasten bei dem Magnetresonanztomographiesystem erfolgt bei der Akquisition entlang einer oder mehrerer Trajektorien. Eine solche Trajektorie kann prinzipiell beliebig gestaltet sein. Vorzugsweise handelt es sich jedoch um eine Spirale. Eine solche spiralförmige k-Raum-Trajektorie besitzt keine Singularitäten und kann in einfacher Weise durch sinusförmig oszillierende ansteigende beziehungsweise abfallende Gradienten erzeugt werden. Sie erlaubt es, den k-Raum in sehr kurzer Zeit zu durchlaufen und wird daher bevorzugt für schnelle Bildgebung eingesetzt, beispielsweise in der Herz-Bildgebung.

Weiterhin kann erfindungsgemäß ein Computerprogrammprodukt vorgesehen sein, welches direkt in einen Speicher einer Steuereinrichtung eines Magnetresonanztomographiesystems ladbar ist, mit Programmmitteln, um die Schritte des oben genannten Verfahrens auszuführen, wenn das Programm in der Steuereinrichtung des Magnetresonanztomographiesystems ausgeführt wird. Das hierin beschriebene Verfahren kann also auch in Form eines Computerprogrammprodukts vorliegen, das das Verfahren auf einer Steuereinheit implementiert, wenn es auf der Steuereinheit ausgeführt wird. Ebenso kann ein elektronisch lesbarer Datenträger mit darauf abgespeicherten elektronisch lesbaren Steuerinformationen vorliegen, welche zumindest ein beschriebenes Computerprogrammprodukt umfassen und derart ausgestaltet sind, dass sie bei der Verwendung des Datenträgers in einer Steuereinheit einer MR-Anlage ein beschriebenes Verfahren durchführen.

Die vorliegende Erfindung wird nun anhand der beigefügten Zeichnungen näher erläutert, in denen zeigen:
- FIG 1: ein schematisches Diagramm eines Magnetresonanztomographiesystems;
- FIG 2: eine schematische Ansicht zweier akquirierter Bilder;
- FIG 3: die beiden Bilder von FIG 2 aufeinander gedreht; und
- FIG 4: ein Ablaufdiagramm eines Ausführungsbeispiels eines erfindungsgemäßen Verfahrens.

Die nachfolgend näher geschilderten Ausführungsbeispiele stellen bevorzugte Ausführungsformen der vorliegenden Erfindung dar.

Die vorliegende Erfindung beruht auf der Idee, dass für die Erkennung von HF-Störungen keine zusätzlichen Antennen und keine HF-Kabine eingesetzt werden müssen. Selbstverständlich können diese Komponenten jedoch ergänzt hinzugezogen werden. Grundsätzlich soll hier aber das Störsignal aus Daten der herkömmlichen MR-Spulen erkannt werden können.

Speziell soll z.B. eine automatische Erkennung von HF-Störern in einer (beispielsweise zeitlich aufgelösten) Reihenfolge spiraler Einzelakquisitionen (Single-Shot-Akquisitionen) erfolgen, wie sie bei schneller zeitlich aufgelöster Bildgebung im interventionellen Bereich oder auch beim MR-Fingerprinting-Verfahren zur Erzeugung der Bilder, anhand derer der Fingerprint erstellt wird. Ziel des vorliegenden Verfahrens ist also nicht das Erkennen von HF-Störungen anhand von nicht erwarteten Ausreißern, etwa im Fingerprinting-Verlauf eines Pixels, sondern die Erkennung von Störern anhand der Störmuster im gesamten Bildraum und deren spezielles Verhalten vor allem bei spiralen Akquisitionen.

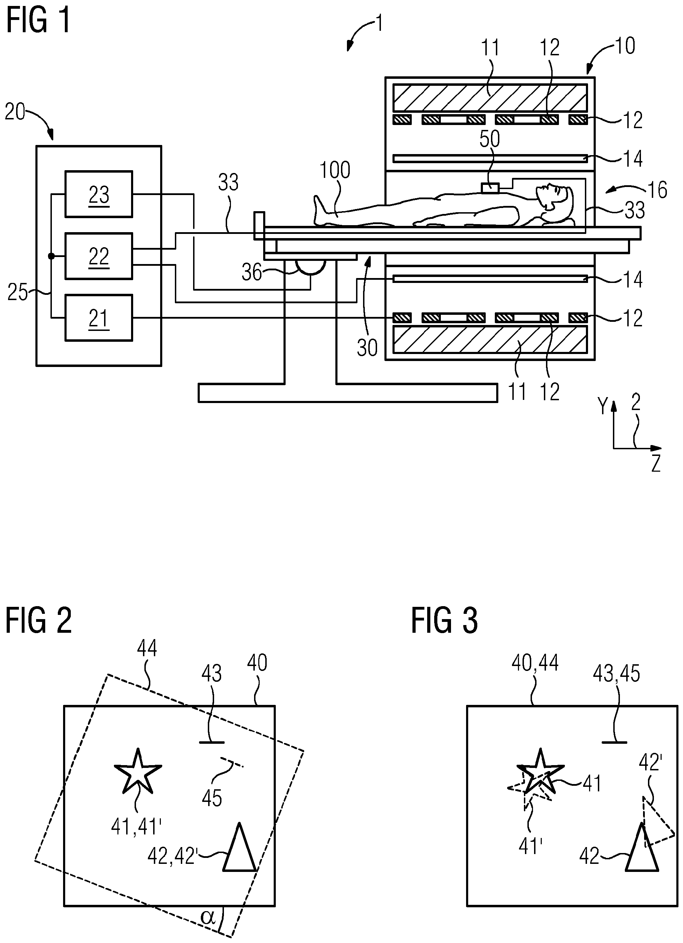

FIG 1 zeigt eine schematische Darstellung einer beispielhaften Ausführungsform eines MRT-Systems 1.

Das MRT-System 1 weist eine Magneteinheit 10 mit einem Feldmagneten 11 auf, der ein statisches Magnetfeld zur Ausrichtung von Kernspins einer Probe, beispielsweise eines Patienten 100, in einem Untersuchungsbereich oder Aufnahmebereich erzeugt. Der Aufnahmebereich zeichnet sich durch ein äußerst homogenes statisches Magnetfeld auf, wobei die Homogenität insbesondere die Magnetfeldstärke beziehungsweise deren Betrag betrifft. Der Aufnahmebereich ist beispielweise nahezu kugelförmig und in einem Patiententunnel 16 positioniert, der sich in einer Längsrichtung 2 durch die Magneteinheit 10 erstreckt. Bei dem Feldmagneten 11 kann es sich beispielsweise um einen supraleitenden Magneten handelt, der magnetische Felder mit einer magnetischen Flussdichte von bis zu 3 T oder mehr bereitstellen kann. Für geringere Feldstärken können jedoch auch Permanentmagnete oder Elektromagnete mit normalleitenden Spulen Verwendung finden. Eine Patientenliege 30 kann in dem Patiententunnel 16 von einer Verfahreinheit 36 bewegbar sein.

Weiterhin weist die Magneteinheit 10 Gradientenspulen 12 auf, die dazu ausgelegt sind, zur räumlichen Differenzierung der erfassten Abbildungsbereiche in dem Aufnahmebereich dem statischen Magnetfeld ortsabhängige Magnetfelder in den drei Raumrichtungen zu überlagern. Die Gradientenspulen 12 können beispielsweise als Spulen aus normalleitenden Drähten ausgestaltet sein, die beispielsweise zueinander orthogonale Felder oder Feldgradienten in dem Aufnahmebereich erzeugen können.

Die Magneteinheit 10 kann als Sendeantenne beispielsweise eine Körperspule 14 aufweisen, die dazu ausgelegt ist, ein über eine Signalleitung zugeführtes Hochfrequenzsignal in den Untersuchungsbereich abzustrahlen. Die Körperspule 14 kann in manchen Ausführungsformen auch dazu genutzt werden, von dem Patienten 100 emittierte Resonanzsignale zu empfangen und über eine Signalleitung abzugeben. Die Körperspule 14 kann in solchen Ausführungsformen also als Hauptempfangsantenne sowie als Sendeantenne dienen.

Das MRT-System 1 weist eine Steuereinheit 20 auf, die die Magneteinheit 10 mit verschiedenen Signalen für die Gradientenspulen 12 und die Körperspule 14 versorgen kann und die empfangenen Signale auswerten kann. Die Steuereinheit 20 kann beispielsweise eine Gradientensteuerung 21 aufweisen, die dazu ausgelegt ist, die Gradientenspulen 12 über Zuleitungen mit variablen Strömen zu versorgen, welche zeitlich koordiniert die gewünschten Gradientenfelder in dem Untersuchungsbereich bereitstellen können.

Die Steuereinheit 20 kann auch eine Hochfrequenzeinheit 22 aufweisen, die dazu ausgelegt ist, Hochfrequenzpulse oder Anregungspulse mit vorgegebenen zeitlichen Verläufen, Amplituden und spektraler Leistungsverteilung zur Anregung einer Magnetresonanz der Kernspins in dem Patienten 100 zu erzeugen. Dabei können Pulsleistungen im Bereich von Kilowatt eingesetzt werden. Die Anregungspulse können über die Körperspule 14 oder über eine oder mehrere lokale Sendeantennen in den Patienten 100 abgestrahlt werden. Die Steuereinheit 20 kann auch eine Steuerung 23 enthalten, die über einen Signalbus 25 mit der Gradientensteuerung 21 und der Hochfrequenzeinheit 22 kommunizieren kann.

Optional kann in der unmittelbaren Umgebung des Patienten 100, beispielsweise auf dem Patienten 100 oder in der Patientenliege 30, eine Lokalspule 50 angeordnet sein, die über eine Anschlussleitung 33 mit der Hochfrequenzeinheit 22 verbunden sein kann. Je nach Ausgestaltungsform kann die Lokalspule 50 alternativ oder zusätzlich zur Körperspule 14 als Hauptempfangsantenne dienen.

Während in kartesischen MR-Akquisitionen HF-Störer im Bild meist durch einzelne Punkte im Bild oder gepunktete Linien im Bild erkennbar sind, zeichnen sie sich in radialen Akquisitionen oft durch gekreuzte gepunktete Linien, ähnlich der im k-Raum akquirierten radialen Speichen aus.

Bei spiralen Datenakquisitionen folgen die Artefakte durch den Störer meist auch einer spiralen Kurve im Ortsraum. Besonders sind sie auch dadurch gekennzeichnet, dass sie vom Startwinkel der Spirale abhängen und sich somit bei Rotation der Spirale um einen Winkel α im k-Raum, wie er häufig bei aufeinanderfolgenden Single-Shot-Akquisitionen verwendet wird, auch um einen Winkel von α im k-Raum drehen. Single-Shot-Spiralen erlauben die Rekonstruktion eines erkennbaren Bildes aus Daten, die in einem sehr kurzen Zeitraum und in Serie schnell hintereinander (jeweils wenige ms) akquiriert werden. Störwellen haben oft über diesen Zeitraum konstante Eigenschaften.

In dem folgenden Beispiel werden die oben genannten Gegebenheiten ausgenutzt, so dass in einer Abfolge von beispielsweise spiralen Single-Shot-Akquisitionen (Einzelakquisitionen) gezielt nach HF-Störern gesucht werden kann. Speziell soll der Drehwinkel zwischen den Einzelakquisitionen berücksichtigt und die Einzelbilder miteinander korreliert werden.

Die FIG 2 und 3 zeigen diese Vorgehensweise. Gemäß FIG 2 wird eine erste Einzelakquisition in einer ersten Abtaststartposition durchgeführt, woraus sich ein erstes Bild 40 ergibt. Dieses Bild 40 beinhaltet hier einen Stern 41 und ein Dreieck 42. Diese beiden Bildkomponenten 41 und 42 repräsentieren das aufzunehmende Objekt und stehen symbolisch für Einzelkomponenten des Objekts. In dem hier quadratischen ersten Bild 40 befindet sich der Stern 41 oben links und das Dreieck 42 unten rechts. Darüber hinaus befindet sich in dem ersten Bild 40 oben rechts ein linienförmiges Artefakt 43, das hier parallel zum oberen Rand des ersten Bilds 40 ausgerichtet ist. Dieses Artefakt 43 entstand durch eine HF-Störung in dem vorliegenden Magnetresonanztomographiesystem.

Bei einer nachfolgenden zweiten Einzelakquisition, die unmittelbar auf die erste Einzelakquisition oder nach einer oder mehreren dazwischenliegenden Einzelakquisitionen folgt, wird die Trajektorie um einen Winkel α gedreht. Die Abtaststartposition wird also um diesen Winkel α gedreht, so dass sich ein zweites Bild 44 ergibt, das um den Winkel α gegenüber dem ersten Bild 40 gedreht ist. Die Einzelkomponenten, nämlich der Stern 41 und das Dreieck 42, sind örtlich unverändert, und es hat sich lediglich die Abtaststartposition um den Winkel α gedreht. Folglich ergeben sich in dem Bild die korrespondierenden Bildkomponenten 41' und 42' für den Stern und das Dreieck. Diese liegen direkt über den Bildkomponenten 41 und 42 von Bild 40.

In dem zweiten Bild 44 befindet sich ein Artefakt 45, das sich an der gleichen Relativposition im Bild 44 befindet wie das Artefakt 43 im ersten Bild 40. Dieses Artefakt 45 hat die gleiche linienförmige Struktur und Ausdehnung wie das Artefakt 43 des ersten Bilds 40.

Nun wird das zweite Bild 44 gemäß FIG 3 um den Drehwinkel α auf das erste Bild 40 gedreht. Die Bildrahmen beider Bilder 40, 44 liegen also aufeinander. Durch das Drehen um den Drehwinkel α drehen sich jedoch die Bildkomponenten der Komponenten des Objekts (Stern und Dreieck) der beiden Bilder auseinander. So wandert die Bildkomponente 41` des zweiten Bilds 44 gegenüber der Bildkomponente 41 des ersten Bilds 40 nach links unten. In ähnlicher Weise wandert die Bildkomponente 42` des zweiten Bilds 44 gegenüber der Bildkomponente 42 des ersten Bilds 40 nach oben rechts. Dies liegt daran, dass die Einzelkomponenten des Objekts nicht ortsfest gegenüber der jeweiligen Trajektorie sind. Demgegenüber wandert beim Drehen des zweiten Bilds 44 auf das erste Bild 40 das Artefakt 45 des zweiten Bilds direkt auf das Artefakt 43 des ersten Bilds. Beide Artefakte sind damit deckungsgleich. Eine Korrelation der beiden aufeinander gedrehten Bilder 40 und 44 würde also eine hohe Übereinstimmung im Bereich der Artefakte 43, 45 ergeben und eine geringe Übereinstimmung in den Bereichen der Sterne 41, 41` und der Dreiecke 42, 42`. Die Ursache hierfür liegt darin, dass die Artefakte 43, 45 in ihren jeweiligen Bildern 40, 44 eine feste Relativposition haben. Sie besitzen also immer die gleiche Bildposition. Aus diesem Grund sind sie leicht gegenüber anderen Komponenten zu identifizieren, bei denen die Bildposition von der Drehung abhängt.

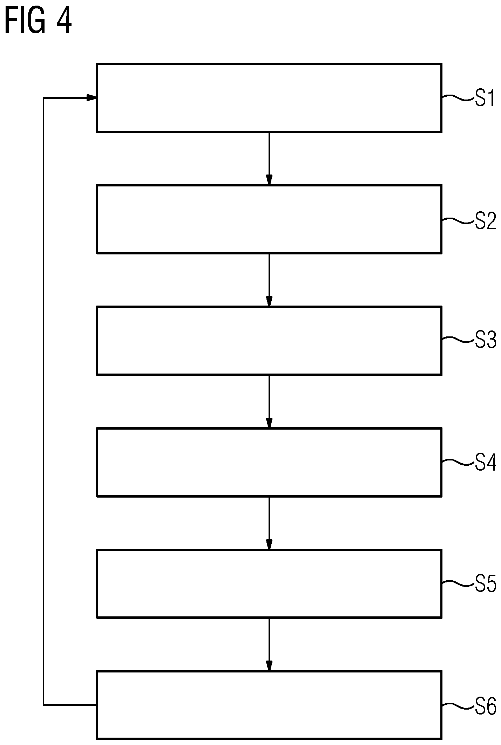

In FIG 4 ist ein Ablaufdiagramm eines erfindungsgemäßen Ausführungsbeispiels dargestellt. In einem ersten Schritt S1 erfolgt das Ausführen einer Akquisition, bei der ein Abtasten des k-Raums entlang einer Trajektorie erfolgt, wobei ein Drehwinkel α zwischen einer Abtaststartposition einer ersten Einzelakquisition und einer Abtaststartposition einer folgenden zweiten Einzelakquisition besteht. Insbesondere kann die Akquisition eine Abfolge spiraler Single-Shot-Akquisitionen beinhalten. Diese zeichnet sich dadurch aus, dass sich von Einzelakquisition zu Einzelakquisition der Startwinkel der Spirale ändert, meist um einen konstanten Winkel α.

In einem zweiten Schritt S2 wird ein erstes Bild 40 aus der ersten Einzelakquisition und ein zweites Bild 44 aus der zweiten Einzelakquisition gewonnen. Dazu werden die jeweiligen Datensätze der Einzelakquisitionen mit geeigneten Bildverarbeitungsalgorithmen verarbeitet.

Nun werden die beiden Bilder 40 und 44 korreliert. Dazu werden die beiden Bilder 40, 44 gegenüber einander um den Winkel α in Schritt S3 gedreht. Die Artefakte treten bevorzugt punktförmig auf, wobei der Ort der Punkte im Bildraum von der jeweiligen Trajektorie des Scanners (z.B. Spirale) abhängt. Ändert sich beispielsweise der Startwinkel der Spiraltrajektorie im k-Raum, drehen sich die Störpunkte im Bildraum entsprechend mit. Werden die Bilder 40, 44, die nun um den Winkel α aufeinander gedreht sind, miteinander korreliert, so ergeben sich hohe Korrelationswerte im Bereich der Artefakte, deren relative Bildpositionen in beiden Bildern 40, 44 unverändert sind. D.h., die Störpunkte der Artefakte überlagern sich. Dies ist zumindest dann der Fall, wenn sich die Charakteristik des HF-Störers zwischen den zumindest zwei Bildern 40, 44 nicht wesentlich ändert.

Nun können in Schritt S5 die überlagerten Punkte identifiziert werden, indem beispielsweise ein geeigneter Mustererkennungsalgorithmus angewandt wird. Zur Identifikation der durch den HF-Störer hervorgerufenen Artefakte kann aber auch eine Subtraktion oder ein Schwellwertvergleich der Bilder angewandt werden, da die Signalintensität der Störer oft höher als das umgebende MR-Signal ist. Alternativ oder zusätzlich kann zur Identifikation der Artefakte beziehungsweise HF-Störer ein Machine Learning (maschinelles Lernen) beziehungsweise ein Deep-Learning-Algorithmus basierend auf einem neuronalen Netz eingesetzt werden.

Schließlich kann in einem weiteren Schritt S6 ein identifizierter Störpunkt in den Bildern markiert, gelöscht oder ersetzt werden. Dies bedeutet, dass die erkannten Störpunkte im Bild entweder als gestörte Punkte markiert werden oder beispielsweise auch gelöscht und durch entweder Punkte mit einem vorgegebenen Wert ersetzt oder durch Interpolation der umgebenden Punkte überschrieben werden. Im Falle einer MR-Fingerprinting-Messung können die identifizierten Punkte im Fingerprinting-Abgleich ignoriert werden.

Das Verfahren kann über die gesamte Messung durchgeführt werden. Daher kann in FIG 4 von Schritt S6 (gegebenenfalls auch von Schritt S5) auf Schritt S1 zurückgesprungen werden, wodurch sich eine Ablaufschleife ergibt. Ein Unterbrechungskriterium wäre beispielsweise das Ende der Messung.

In einer weiteren Ausführungsform kann es ermöglicht werden, nicht nur aufeinanderfolgende Bilder, sondern beliebige Bilder der Serie miteinander zu korrelieren.

Das Verfahren kann möglicherweise nicht direkt zur Bildgewinnung eingesetzt werden, sondern als zusätzliche Messung - ähnlich einer Justage - zur Identifikation von zeitlich langsam veränderlichen Störern. Dann wäre auch der Einsatz anderer k-Raum-Trajektorien als Ersatz für Spiralen denkbar, welche für die Erkennung von typischen Störsignalen optimiert sind.

Ein beispielhaftes Magnetresonanztomographiesystem besitzt zur Durchführung des oben genannten Verfahrens zum Erkennen einer HF-Störung bei der Bildgebung eine Tomographieeinrichtung gemäß FIG 1 und eine Bildverarbeitungseinrichtung, die beispielsweise einen Prozessor aufweist, mit dem die Bilder gewonnen und gedreht sowie die Korrelation durchgeführt werden kann.

Im Falle einer zeitaufgelösten Echtzeit-Bildgebung kann das Verfahren bei vorhandener Rechenleistung auch in Echtzeit angewandt werden.

Mit dem oben vorgestellten Verfahren wird das Erkennen von HF-Störern in Bildserien von z.B. spiralen Einzelakquisitionen ermöglicht, indem das Wissen über die Akquisition (hier der Startwinkel der spiralen Akquisition und deren Veränderung über die Bildserie sowie das sich dadurch ändernde Muster von Störungen im Bildraum) ausgenutzt wird. Der Vorteil dieses Verfahrens ist, dass es ohne weitere Hardware, wie die im Zusammenhang von Messungen ohne HF-Kabine oft benötigten Pick-up-Antennen, auskommt und so preisgünstig umgesetzt werden kann. Es ist jedoch auch möglich, das Verfahren in Kombination mit bisherigen Ansätzen auszuführen und so eine Verbesserung des Gesamt-Entstörungs-ergebnisses zu erreichen.

## Patentansprüche

1. Verfahren zum Erkennen einer HF-Störung bei der Bildgebung eines Magnetresonanztomographiesystem (1) durch
- Ausführen (S1) einer Akquisition, bei der eine Abtastung eines k-Raums entlang einer Trajektorie erfolgt, wobei ein Drehwinkel α zwischen einer Abtaststartposition einer ersten Einzelakquisition und einer Abtaststartposition einer folgenden zweiten Einzelakquisition besteht, und
- Gewinnen (S2) eines ersten Bilds (40) aus der ersten Einzelakquisition und eines zweiten Bilds (44) aus der zweiten Einzelakquisition,
**gekennzeichnet durch**
- Drehen (S3) eines der beiden Bilder gegenüber dem anderen Bild um den Drehwinkel α, sodass die Drehung auf der Bildebene rückgängig gemacht wird,
- Ermitteln (S4) einer Korrelation zwischen dem einen gedrehten und dem anderen Bild und
- Identifizieren (S5) eines durch die HF-Störung verursachten Störpunkts aus der Korrelation.

2. Verfahren nach Anspruch 1, wobei bei dem Ausführen (S1) der Akquisition mindestens eine weitere Einzelakquisition erfolgt, bei der die Abtaststartposition wiederum um einen Drehwinkel α gegenüber der zweiten Einzelakquisition gedreht ist, und aus der mindestens einen weiteren Einzelakquisition mindestens ein weiteres Bild gewonnen wird, das entsprechend gedreht bei der Korrelation berücksichtigt wird.

3. Verfahren nach Anspruch 1 oder 2, wobei das Identifizieren (S5) des Störpunkts durch einen Mustererkennungsalgorithmus erfolgt.

4. Verfahren nach einem der vorhergehenden Ansprüche, wobei das Identifizieren (S5) des Störpunkts einen Vergleich mit einem Schwellwert beinhaltet.

5. Verfahren nach einem der vorhergehenden Ansprüche, wobei die Korrelation durch eine Subtraktion betroffener Bilder ermittelt wird.

6. Verfahren nach einem der vorhergehenden Ansprüche, wobei das Identifizieren (S5) des Störpunkts auf einem maschinellen Lernalgorithmus, insbesondere einem Deep-Learning-Algorithmus, basiert.

7. Verfahren nach einem der vorhergehenden Ansprüche, wobei der identifizierte Störpunkt in den Bildern (40, 44) markiert, gelöscht oder ersetzt wird.

8. Verfahren nach einem der vorhergehenden Ansprüche, wobei die Trajektorie, entlang der die Abtastung erfolgt, eine Spirale ist.

9. Computerprogrammprodukt, welches direkt in einen Speicher einer Steuereinrichtung (20) eines Magnetresonanztomographiesystems (1) ladbar ist, das eine Tomographieeinrichtung und eine Bildverarbeitungseinrichtung umfasst, mit Programmmitteln, um die Schritte des Verfahrens nach einem der vorhergehenden Ansprüche auszuführen, wenn das Programm in der Steuereinrichtung (20) des Magnetresonanztomographiesystems (1) ausgeführt wird.

10. Magnetresonanztomographiesystem (1) zum Erkennen einer HF-Störung bei der Bildgebung mit
- einer Tomographieeinrichtung zum Ausführen einer Akquisition, bei der eine Abtastung eines k-Raums entlang einer Trajektorie erfolgt, wobei ein Drehwinkel α zwischen einer ersten Einzelakquisition und einer folgenden zweiten Einzelakquisitionen besteht, und
- einer Bildverarbeitungseinrichtung zum Gewinnen eines ersten Bilds aus der ersten Einzelakquisition und eines zweiten Bilds aus der zweiten Einzelakquisition,
**dadurch gekennzeichnet, dass**
- die Bildverarbeitungseinrichtung ausgebildet ist zum Drehen eines der beiden Bilder gegenüber dem anderen Bild um den Drehwinkel α, sodass die Drehung auf der Bildebene rückgängig gemacht wird, zum Ermitteln einer Korrelation zwischen dem einen gedrehten und dem anderen Bild und zum Identifizieren eines durch die HF-Störung verursachten Störpunkts aus der Korrelation.

## Claims

1. Method for identifying RF interference in imaging of a magnetic resonance tomography system (1) by
- performance (S1) of an acquisition, in which a scan of a k-space along a trajectory takes place, wherein an angle of rotation α exists between a scan start position of a first individual acquisition and a scan start position of a following second individual acquisition, and
- capture (S2) of a first image (40) from the first individual acquisition and of a second image (44) from the second individual acquisition,
**characterised by**
- rotation (S3) of one of the two images in respect of the other image about the angle of rotation α, such that the rotation is reversed in the image plane,
- determination (S4) of a correlation between the one rotated image and the other image and
- identification (S5) of a point of interference, caused by the RF interference, from the correlation.

2. Method according to claim 1, wherein during the performance (S1) of the acquisition at least one further individual acquisition takes place, in which the scan start position is again rotated about an angle of rotation α in respect of the second individual acquisition, and at least one further image is captured from the at least one further individual acquisition and, correspondingly rotated, is taken into account in the correlation.

3. Method according to claim 1 or 2, wherein the identification (S5) of the point of interference takes place using a pattern recognition algorithm.

4. Method according to one of the preceding claims, wherein the identification (S5) of the point of interference includes a comparison with a threshold value.

5. Method according to one of the preceding claims, wherein the correlation is determined by a subtraction of relevant images.

6. Method according to one of the preceding claims, wherein the identification (S5) of the point of interference is based on a machine learning algorithm, in particular a deep-learning algorithm.

7. Method according to one of the preceding claims, wherein the identified point of interference is marked, deleted or replaced in the images (40, 44).

8. Method according to one of the preceding claims, wherein the trajectory, along which the scanning takes place, is a spiral.

9. Computer program product, which can be loaded directly into a memory of a control device (20) of a magnetic resonance tomography system (1), which comprises a tomography device and an image processing device, with program means in order to execute the steps of the method according to one of the preceding claims, when the program is executed in the control device (20) of the magnetic resonance tomography system (1).

10. Magnetic resonance tomography system (1) for identifying RF interference in imaging with
- a tomography device for performing an acquisition, in which a scan of a k-space takes place along a trajectory, wherein an angle of rotation α exists between a first individual acquisition and a following second individual acquisition, and
- an image processing device for the capture of a first image from the first individual acquisition and of a second image from the second individual acquisition,
**characterised in that**
- the image processing device is designed to rotate one of the two images in respect of the other image about the angle of rotation α, such that the rotation is reversed in the image plane, for determining a correlation between the one rotated image and the other image and for identifying a point of interference, caused by the RF interference, from the correlation.

## Revendications

1. Procédé de détection d'interférences HF, lors de l'imagerie d'un système (1) de tomodensitométrie par résonnance magnétique en
- exécutant (S1) une acquisition, dans laquelle un échantillonnage d'un espace k s'effectue le long d'une trajectoire, dans lequel il y a un angle α de rotation entre une position de début d'échantillonnage d'une première acquisition individuelle et une position de début d'échantillonnage d'une deuxième acquisition individuelle suivante, et
- obtenant (S2) une première image (40) à partir de la première acquisition individuelle et une deuxième image (44) à partir de la deuxième acquisition individuelle,
**caractérisé par**
- une rotation (S3) de l'une des deux images par rapport à l'autre image de l'angle a de rotation, de manière à annuler la rotation sur le plan image,
- une détermination (S4) d'une corrélation entre l'image tournée et l'autre image et
- une identification (S5) à partir de la corrélation d'un point d'interférence provoqué par l'interférence HF.

2. Procédé suivant la revendication 1, dans lequel, lors de l'exécution (S1) de l'acquisition, il est effectué au moins une autre acquisition individuelle, dans laquelle la position de début d'échantillonnage est tournée à nouveau d'un angle α de rotation par rapport à la deuxième acquisition individuelle et, à partir de la au moins une autre acquisition individuelle, on obtient au moins une autre image, qui, tournée de manière correspondante, est prise en compte lors de la corrélation.

3. Procédé suivant la revendication 1 ou 2, dans lequel l'identification (S5) du point d'interférence s'effectue par un algorithme de reconnaissance de forme.

4. Procédé suivant l'une des revendications précédentes, dans lequel l'identification (S5) du point d'interférence comporte une comparaison à une valeur de seuil.

5. Procédé suivant l'une des revendications précédentes, dans lequel on détermine la corrélation par une soustraction d'images concernées.

6. Procédé suivant l'une des revendications précédentes, dans lequel l'identification (S5) du point d'interférence repose sur un algorithme d'apprentissage automatique, en particulier un algorithme deep learning.

7. Procédé suivant l'une des revendications précédentes, dans lequel on repère, on efface ou on remplace le point d'interférence identifié dans les images (40, 44).

8. Procédé suivant l'une des revendications précédentes, dans lequel la trajectoire le long de laquelle s'effectue l'échantillonnage est une spirale.

9. Produit de programme d'ordinateur, qui peut être chargé directement dans la mémoire d'un dispositif (20) de commande d'un système (1) de tomodensitométrie par résonnance magnétique, qui comprend un dispositif de tomodensitométrie et un dispositif de traitement d'image, comprenant des moyens de programme pour exécuter les stades du procédé suivant l'une des revendications précédentes, lorsque le programme est exécuté dans le dispositif (20) de commande du système (1) de tomodensitométrie par résonnance magnétique.

10. Système (1) de tomodensitométrie par résonnance magnétique pour la détection d'une interférence HF, lors de l'imagerie, comprenant
- un dispositif de tomodensitométrie pour l'exécution d'une acquisition, dans laquelle un échantillonnage d'un espace k s'effectue le long d'une trajectoire, dans lequel il y a un angle α de rotation entre une position de début d'échantillonnage d'une première acquisition individuelle et une position de début d'échantillonnage d'une deuxième acquisition individuelle suivante, et
- un dispositif de traitement d'image pour l'obtention d'une première image à partir de la première acquisition individuelle et d'une deuxième image à partir de la deuxième acquisition individuelle,
**caractérisé en ce que**
- le dispositif de traitement d'image est constitué pour faire tourner l'une des images par rapport à l'autre image de l'angle α de rotation, de manière à annuler la rotation sur le plan image, pour la détermination d'une corrélation entre l'image tournée et l'autre image et pour l'identification à partir de la corrélation d'un point d'interférence provoqué par l'interférence HF.
